# EUROPÄISCHE PATENTSCHRIFT

(11) **EP 2 655 963 B1**
(45) Veröffentlichungstag und Bekanntmachung des Hinweises auf die Patenterteilung: **07.01.2015**
(21) Anmeldenummer: 12721785.9
(22) Anmeldetag: 23.04.2012
(51) Int. Cl.: F21V 31/04, F21S 4/00, F21Y 101/02, F21Y 103/00

(54) **LEUCHTVORRICHTUNG UND VERFAHREN ZUM HERSTELLEN EINER LEUCHTVORRICHTUNG**
LIGHTING DEVICE AND METHOD FOR PRODUCING A LIGHTING DEVICE
DISPOSITIF D'ÉCLAIRAGE ET PROCÉDÉ POUR FABRIQUER UN DISPOSITIF D'ÉCLAIRAGE

(30) Priorität: 29.04.2011 DE 102011075032
(43) Veröffentlichungstag der Anmeldung: 30.10.2013
(73) Patentinhaber: OSRAM GmbH, 80807 München (DE)
(72) Erfinder: REISS, Martin, 93161 Sinzing (DE); HOLZAPFEL, Gerhard, 94369 Rain (DE); STRAUSS, Steffen, 93152 Nittendorf (DE)
(86) Internationale Anmeldenummer: PCT/EP2012/057358
(87) Internationale Veröffentlichungsnummer: WO 2012/146555

(56) Entgegenhaltungen:
- EP-A2- 0 760 448
- WO-A1-2010/130735
- DE-A1-102007 028 463
- DE-A1-102009 019 285

## Beschreibung

Die Erfindung betrifft eine Leuchtvorrichtung, aufweisend mindestens eine mit mindestens einer ersten Vergussmasse vergossene Halbleiterlichtquelle, wobei mindestens ein Bereich der Leuchtvorrichtung mindestens ein Anschlussfeld, das mit der mindestens einen Halbleiterlichtquelle elektrisch verbunden ist, und mindestens ein elektrisches Verbindungselement aufweist.

Bisher sind LED-Bänder bekannt, welche eine bandförmige Leiterplatte aufweisen, die einseitig mit einer Reihe von Leuchtdioden bestückt ist. Die Leuchtdioden können zum Schutz vor Staub und/oder Feuchtigkeit in Silikon vergossen sein. Zum elektrischen Anschluss des LED-Bands ist bisher eine elektrische Steckverbindung bekannt, welche ebenfalls auf der Leiterplatte angeordnet ist und welche zunächst vergossen ist. Zu ihrem Gebrauch muss eine die Steckverbindung in Einsteckrichtung bedeckende Vergussmasse entfernt werden, so dass Steckkontakte der Vergussmasse freiliegen. Nachteilig dabei ist, dass dieses Entfernen der Vergussmasse aufwändig ist, insbesondere da die Steckverbindung unter der Vergussmasse typischerweise nicht sichtbar ist.

Es ist ferner bekannt, elektrische Drähte direkt an Anschlussfelder zu löten und diese Drähte dann einzeln aus der Leuchtvorrichtung herauszuführen. Nachteilig dabei sind ein nicht einheitliches Aussehen, die Schwierigkeit, mehrere der Drähte ohne Kurzschlüsse zu verlöten und eine Unzuverlässigkeit einer folgenden Verkapselung mit Vergussmasse, da die Drähte auch durch die Vergussmasse hindurch an dem Anschlussfeld relativ leicht unter eine Zugbelastung setzbar sind. WO2010/130735 offenbart eine Leuchtvorrichtung gemäß dem Oberbegriff des Anspruchs 1.

Es ist die **Aufgabe** der vorliegenden Erfindung, die Nachteile des Standes der Technik zumindest teilweise zu vermeiden und insbesondere eine einfach herstellbare und optisch ansprechende, vergossene Leuchtvorrichtung bereitzustellen.

Diese Aufgabe wird gemäß den Merkmalen der unabhängigen Ansprüche gelöst. Bevorzugte Ausführungsformen sind insbesondere den abhängigen Ansprüchen entnehmbar.

Die Aufgabe wird gelöst durch eine Leuchtvorrichtung, aufweisend mindestens eine mit mindestens einer ersten Vergussmasse vergossene Halbleiterlichtquelle, wobei mindestens ein Bereich der Leuchtvorrichtung aufweist: mindestens ein Anschlussfeld, das mit der mindestens einen Halbleiterlichtquelle elektrisch verbunden ist und mindestens ein elektrisches Verbindungselement, das mindestens eine elektrische Leitung aufweist, wobei mindestens eine elektrische Leitung mit einem zugehörigen Anschlussfeld verbunden ist und an einem Ende aus der Leuchtvorrichtung hervorschaut und das mindestens eine Anschlussfeld und das mindestens eine elektrische Verbindungselement in einem Ausschnitt der ersten Vergussmasse angeordnet sind und mittels einer zweiten Vergussmasse vergossen sind.

Die Leuchtvorrichtung kann insbesondere eine Lampe, eine Leuchte oder ein Leuchtmodul sein. Die Leuchtvorrichtung kann insbesondere ein kompaktes Leuchtmodul oder ein bandförmiges Leuchtband sein.

Bevorzugterweise umfasst die mindestens eine Halbleiterlichtquelle mindestens eine Leuchtdiode. Bei Vorliegen mehrerer Leuchtdioden können diese in der gleichen Farbe oder in verschiedenen Farben leuchten. Eine Farbe kann monochrom (z.B. rot, grün, blau usw.) oder multichrom (z.B. weiß) sein. Auch kann das von der mindestens einen Leuchtdiode abgestrahlte Licht ein infrarotes Licht (IR-LED) oder ein ultraviolettes Licht (UV-LED) sein. Mehrere Leuchtdioden können ein Mischlicht erzeugen; z.B. ein weißes Mischlicht. Die mindestens eine Leuchtdiode kann mindestens einen wellenlängenumwandelnden Leuchtstoff enthalten (Konversions-LED). Der Leuchtstoff kann alternativ oder zusätzlich entfernt von der Leuchtdiode angeordnet sein ("remote phosphor"). Die mindestens eine Leuchtdiode kann in Form mindestens einer einzeln gehäusten Leuchtdiode oder in Form mindestens eines LED-Chips vorliegen. Mehrere LED-Chips können auf einem gemeinsamen Substrat ("Submount") montiert sein. Die mindestens eine Leuchtdiode kann mit mindestens einer eigenen und/oder gemeinsamen Optik zur Strahlführung ausgerüstet sein, z.B. mindestens einer Fresnel-Linse, Kollimator, und so weiter. Anstelle oder zusätzlich zu anorganischen Leuchtdioden, z.B. auf Basis von InGaN oder AlInGaP, sind allgemein auch organische LEDs (OLEDs, z.B. Polymer-OLEDs) einsetzbar. Alternativ kann die mindestens eine Halbleiterlichtquelle z.B. mindestens einen Diodenlaser aufweisen.

Dass die mindestens eine Halbleiterlichtquelle mittels mindestens einer ersten Vergussmasse vergossen ist, kann insbesondere umfassen, dass die mindestens eine Halbleiterlichtquelle mittels einer ersten Vergussmasse vergossen ist oder dass die mindestens eine Halbleiterlichtquelle mittels mehrerer Vergussmassen vergossen ist, z.B. mehrerer Lagen unterschiedlicher erster Vergussmassen. Die Vergussmasse kann insbesondere ein Silikonmaterial sein, welches vorteilhafterweise preiswert, langzeitstabil, flexibel und optional transparent oder transluzent ausgestaltbar ist.

Das Anschlussfeld mag insbesondere ein elektrisches Kontaktfeld sein, insbesondere ein ebenes Kontaktfeld. Das elektrische Anschlussfeld mag insbesondere zum Verlöten oder Anschweißen geeignet sein. Das Anschlussfeld kann direkt an der mindestens einen Halbleiterquelle vorhanden sein oder mittels einer elektrischen Verdrahtungsstruktur mit der mindestens einen Halbleiterquelle direkt oder indirekt (z.B. über eine Schaltung oder andere elektrische oder elektronische Bauelemente) verbunden sein.

Die mindestens eine elektrische Leitung kann mit dem zugehörigen Anschlussfeld z.B. durch eine Verlötung oder Verschweißung verbunden sein.

Dadurch, dass die mindestens eine elektrische Leitung an einem Ende aus der Leuchtvorrichtung hervorschaut, kann sie dort extern elektrisch angeschlossen werden, z.B. mit anderen Leuchtvorrichtungen und/oder mit einer externen Stromquelle.

Dass das mindestens eine Anschlussfeld und das mindestens eine elektrische Verbindungselement in einem Ausschnitt oder Aussparung der ersten Vergussmasse angeordnet sind, kann bedeuten, dass das mindestens eine Anschlussfeld und das mindestens eine elektrische Verbindungselement zuvor mit der mindestens einen Vergussmasse bedeckt waren und folgend davon befreit oder freigelegt worden sind. Alternativ mögen das mindestens eine Anschlussfeld und das mindestens eine elektrische Verbindungselement nicht mit der mindestens einen Vergussmasse vergossen worden sein, sondern von deren Verguss ausgespart worden sein.

Dass der mindestens eine Ausschnitt bzw. Aussparung mittels einer zweiten Vergussmasse vergossen sind, bedeutet insbesondere, dass die Halbleiterlichtquellen mittels der mindestens einen ersten Vergussmasse vergossen sind und das mindestens eine Anschlussfeld und das mindestens eine elektrische Verbindungselement benachbart dazu mittels der zweiten Vergussmasse vergossen sind.

Die Leuchtvorrichtung kann einen oder mehrere solche Bereiche aufweisen. Jeder der Bereiche weist vorteilhafterweise einen Ausschnitt und ein elektrisches Verbindungselement auf. Das elektrische Verbindungselement weist bevorzugt mehrere elektrische Leitungen auf, und die Zahl der Anschlussfelder pro Bereich entspricht bevorzugt der Zahl der elektrischen Leitungen des zugehörigen elektrischen Verbindungselements.

Diese Leuchtvorrichtung weist den Vorteil auf, dass die mindestens eine elektrische Leitung vergleichsweise einfach und zuverlässig mit einem jeweiligen Anschlussfeld verbindbar (verlötbar, verschweißbar usw.) ist. Das mindestens eine Anschlussfeld und das mindestens eine elektrische Verbindungselement sind zudem durch die zweite Vergussmasse staub- und feuchtigkeitsschützbar, insbesondere gemäß einer oder mehrerer IP-Schutzklassen. Die Verwendung des Ausschnitts der ersten Vergussmasse ermöglicht zudem einen einfachen und präzisen Verguss. Darüber hinaus ist diese Leuchtvorrichtung mit einem sich nur geringfügig ändernden Herstellungsaufwand bezüglich ihres elektrischen Anschlusses (z.B. der Zahl der elektrischen Leitungen und/oder Anschlussfelder) variierbar. Dies unterstützt eine Massenproduktion der Leuchtvorrichtung. Auch ist eine optisch ansprechende Ausgestaltung möglich. Die Verwendung eines dedizierten elektrischen Verbindungselements ermöglicht zudem eine einfache gleichartige Positionierung der elektrischen Leitungen, auch von Leitungen unterschiedlicher Länge. Zudem wird eine Zugentlastung der elektrischen Leitungen auf einfache Weise ermöglicht, was eine Zuverlässigkeit erhöht.

Es ist eine Ausgestaltung, dass das mindestens eine elektrische Verbindungselement einen Körper aufweist, durch welchen mindestens eine elektrische Leitung hindurchgeführt ist. Die elektrische Leitung ist insbesondere fest in dem Körper eingebracht, um eine Zugentlastung zu begünstigen. Der Körper kann insbesondere ein Kunststoffkörper sein, insbesondere ein Vollkörper. Die mindestens eine elektrische Leitung kann insbesondere ein ummantelter oder blanker Draht sein, insbesondere als Teil eines Kabels.

Es ist noch eine Ausgestaltung, dass der Körper außenseitig mindestens eine Rille aufweist, insbesondere umlaufende Rille. Die mindestens eine Rille unterstützt eine flächige Bedeckung des Körpers mit der zweiten Vergussmasse durch Erzeugung eines Kapillareffekts. Die mindestens eine Rille ermöglicht ferner einen Formschluss des Körpers in der Vergussmasse.

Es ist noch eine weitere Ausgestaltung, dass der Körper außenseitig mindestens einen Abstandshalter aufweist. Dieser mindestens eine Abstandshalter ermöglicht eine Bedeckung einer durch den Abstandshalter beabstandeten Seite des Körpers gegenüber einer benachbarten Wand, insbesondere falls diese Seite des Körpers eine oder mehrere Rillen aufweist.

Es ist auch eine Ausgestaltung, dass der Körper an der Seite, an welcher die mindestens eine zugehörige elektrische Leitung aus der Leuchtvorrichtung hervorschaut, eine seitlich vorstehende, umlaufende Wandung aufweist. Diese Wandung ermöglicht eine Verwendung des Körpers als Stopfen oder Barriere, insbesondere bei einem Einsatz in einem seitlich (nicht endständig) geschlossenen Kanal, so dass der Ausschnitt sicher mit der zweiten Vergussmasse füllbar ist und keine Gefahr besteht, dass die zweite Vergussmasse im Bereich des Körpers aus der Leuchtvorrichtung heraustropft.

Es ist auch eine Ausgestaltung, dass die Wandung eine ungleichmäßige Höhe aufweist. So mag der Körper auch seitlich offene Kanäle bis zu einer der Wandhöhe entsprechenden Einfüllhöhe sicher absperren. Alternativ weist die Wandung eine umlaufend zumindest im Wesentlichen gleichmäßige Höhe auf.

Es ist ferner eine Ausgestaltung, dass das mindestens eine elektrische Verbindungselement zwei oder vier elektrische Leitungen aufweist. Die elektrischen Leitungen sind bevorzugt seitlich zueinander versetzt, um eine einfache Befestigung an dem jeweiligen Anschlussfeld ohne eine Behinderung durch eine benachbarte elektrische Leitung zu ermöglichen.

Es ist noch eine Ausgestaltung, dass das mindestens eine Anschlussfeld bezüglich der mindestens einen ersten Vergussmasse mittels des mindestens einen Ausschnitts freigelegt ist und/oder das mindestens eine elektrische Verbindungselement in einem nach außen führenden, seitlich geschlossenen (rohrförmigen) Kanal untergebracht ist und den Kanal, insbesondere von außen, verschließt. Dass das mindestens eine Anschlussfeld freigelegt ist, insbesondere direkt mit Werkzeug erreichbar ist, ermöglicht eine mit einem geringen Handhabungsaufwand durchzuführende Befestigung der elektrischen Leitung(en) an dem bzw. den Anschlussfeld(ern). Das Vorsehen des Kanals ermöglicht eine einfache Einbringung und definierte Positionierung des Verbindungselements bei einem gleichzeitig tropffreien Verguss.

Es ist außerdem eine Ausgestaltung, dass das mindestens eine Anschlussfeld bezüglich der mindestens einen ersten Vergussmasse mittels des mindestens einen Ausschnitts freilegt ist und das mindestens eine elektrische Verbindungselement in einem nach außen führenden, offenen Kanal untergebracht ist und den Kanal, insbesondere von außen bzw. an einer äußeren Bereich, versperrt oder verschließt. Dies ermögliche eine einfachere Abtragung oder Aussparung der ersten Vergussmasse und einen sichereren Verguss des Verbindungselements.

Es ist noch eine weitere Ausgestaltung, dass das mindestens eine Anschlussfeld gegenüber der das mindestens eine Anschlussfeld direkt bedeckenden ersten Vergussmasse (insbesondere aber nicht gegenüber der zweiten Vergussmasse) inhibitiert ist. Dies ermöglicht ein einfaches und insbesondere restefreies Entfernen der ersten Vergussmasse von dem mindestens einen Anschlussfeld, was wiederum eine Verbindungssicherheit mit einer später anzuschließenden elektrischen Leitung verbessert. Das Inhibitieren unterdrückt somit insbesondere eine Haftung der ersten Vergussmasse an dem Anschlussfeld.

Es ist auch eine Ausgestaltung, dass eine das mindestens eine Anschlussfeld direkt bedeckende erste Vergussmasse und die zweite Vergussmasse unterschiedlich sind. So mag das Inhibitieren nicht gegenüber der zweiten Vergussmasse wirken.

Ganz allgemein mögen mindestens eine erste Vergussmasse und die zweite Vergussmasse ein gleiches Material aufweisen. Alternativ mögen mindestens eine erste Vergussmasse und die zweite Vergussmasse ein gleiches Basismaterial, z.B. Silikon, aber andere Füllstoffe aufweisen. In noch einer Alternative mögen mindestens eine erste Vergussmasse und die zweite Vergussmasse ein unterschiedliches Basismaterial, z.B. Silikon bzw. ABS, aufweisen, beispielsweise mit gleichen oder unterschiedlichen Füllstoff(en).

Die mindestens eine erste Vergussmasse mag eine einzige erste Vergussmasse oder mehrere verschiedene, räumlich unterschiedlich angeordnete erste Vergussmassen aufweisen, z.B. mehrere Lagen von Vergussmassen.

Es ist außerdem eine Ausgestaltung, dass die mindestens eine erste Vergussmasse eine untere (erste erste) Vergussmasse, mittels welcher die mindestens eine Halbleiterlichtquelle bis unterhalb ihrer Emitterfläche vergossen ist, und eine obere (zweite erste) Vergussmasse, mittels welcher die Emitterfläche vergossen ist, aufweist. Durch die untere Vergussmasse kann eine Einsicht auf die mindestens eine Halbleiterlichtquelle und ein darunterliegendes Substrat beeinflusst, insbesondere verhindert werden, was eine Anmutung der Leuchtvorrichtung verbessert. Die untere Vergussmasse mag dazu insbesondere blickdicht sein. Die obere Vergussmasse kann zur Unterdrückung eines optischen Verlusts insbesondere transparent sein. Die obere Vergussmasse kann zur Homogenisierung des abgestrahlten Lichts insbesondere transluzent sein.

Die mindestens eine Halbleiterlichtquelle kann auf einem Substrat angeordnet sein. Mehrere Halbleiterlichtquellen können auf einem gemeinsamen Substrat angeordnet sein. Das Substrat kann insbesondere eine Leiterplatte sein. Die Leiterplatte kann insbesondere eine kreisscheibenförmige oder eine bandförmige Leiterplatte sein.

Die Leiterplatte kann insbesondere eine mechanisch flexible Leiterplatte sein, insbesondere eine bandförmige flexible Leiterplatte. Insbesondere können Leuchtbänder der LINEARlight Flex-Serie der Fa. Osram verwendet werden. Insbesondere zusammen mit elastischen Vergussmassen kann so eine insgesamt elastisch verformbare Leuchtvorrichtung bereitgestellt werden, insbesondere im Sinne eines gekapselten Leuchtbands.

Es ist ferner eine Ausgestaltung, dass die Leuchtvorrichtung ein Leuchtband (mit einem bandförmigen, flexiblen oder nicht flexiblen Substrat) ist und die Bereiche der Leuchtvorrichtung (welche jeweils mindestens ein Anschlussfeld aufweisen) endständige Bereiche sind, und zwar einseitig oder beidseitig.

Die Aufgabe wird auch gelöst durch ein Verfahren zum Herstellen einer Leuchtvorrichtung, aufweisend mindestens die folgenden Schritte: Bereitstellen einer Leuchtvorrichtung, welche mindestens eine Halbleiterlichtquelle sowie mindestens ein Anschlussfeld, das mit der mindestens einen Halbleiterlichtquelle elektrisch verbunden ist, aufweist, welche mittels mindestens einer ersten Vergussmasse vergossen sind; Entfernen eines Teils der ersten Vergussmasse, so dass das mindestens eine Anschlussfeld freiliegt und über einen Kanal mit einer Außenseite verbunden ist; Einführen eines elektrischen Verbindungselements mit mindestens einer elektrischen Leitung in den Kanal, so dass das elektrische Verbindungselement den Kanal absperrt und die elektrische Leitung nach außen vorsteht; Verbinden mindestens einer elektrischen Leitung des elektrischen Verbindungselements mit einem jeweiligen Anschlussfeld; und Vergießen des mindestens einen Anschlussfelds und des mindestens einen elektrischen Verbindungselements mit mindestens einer zweiten Vergussmasse.

Dadurch werden die gleichen Vorteile wie bei der oben beschriebenen Leuchtvorrichtung erreicht. Auch kann das Verfahren analog zu der Leuchtvorrichtung ausgestaltet werden.

Beispielsweise kann es eine Ausgestaltung sein, dass das Verfahren die folgenden vorangehenden Schritte aufweist: Inhibitieren des mindestens einen Anschlussfelds; Vergießen der mindestens einen Halbleiterlichtquelle sowie des mindestens einen Anschlussfelds mit der mindestens einen ersten Vergussmasse, wobei das Inhibitieren des mindestens einen Anschlussfelds ein Inhibitieren gegenüber der das mindestens eine Anschlussfeld direkt bedeckenden ersten Vergussmasse umfasst.

In den folgenden Figuren wird die Erfindung anhand von Ausführungsbeispielen schematisch genauer beschrieben. Dabei können zur Übersichtlichkeit gleiche oder gleichwirkende Elemente mit gleichen Bezugszeichen versehen sein.
- Fig.1: zeigt in Draufsicht einen endseitigen Ausschnitt aus einem LED-Leuchtband als Vorstufe einer erfindungsgemäßen Leuchtvorrichtung gemäß einer ersten Ausführungsform;
- Fig.2: zeigt in Seitenansicht einen Ausschnitt aus einem auf einen Träger aufgebrachten LED-Leuchtband in einer weiteren Vorstufe der erfindungsgemäßen Leuchtvorrichtung;
- Fig.3: zeigt als Schnittdarstellung in Seitenansicht einen Ausschnitt aus einem nun vergossenen LED-Leuchtband als einer weiteren Vorstufe der erfindungsgemäßen Leuchtvorrichtung;
- Fig.4: zeigt als Schnittdarstellung in Seitenansicht einen Ausschnitt aus dem vergossenen LED-Leuchtband in noch einer weiteren Vorstufe der erfindungsgemäßen Leuchtvorrichtung;
- Fig.5: zeigt in Seitenansicht ein elektrisches Verbindungselement der erfindungsgemäßen Leuchtvorrichtung;
- Fig.6: zeigt in Frontalansicht eine Endfläche der unfertigen Leuchtvorrichtung mit dem eingesetzten elektrischen Verbindungselement;
- Fig.7: zeigt als Schnittdarstellung in Seitenansicht einen Ausschnitt aus noch einer weiteren Vorstufe der erfindungsgemäßen Leuchtvorrichtung mit dem eingesetzten Verbindungselement;
- Fig.8: zeigt als Schnittdarstellung in Seitenansicht einen Ausschnitt aus noch einer weiteren Vorstufe der erfindungsgemäßen Leuchtvorrichtung;
- Fig.9: zeigt als Schnittdarstellung in Seitenansicht die fertige erfindungsgemäße Leuchtvorrichtung gemäß der ersten Ausführungsform;
- Fig.10: zeigt als Schnittdarstellung in Seitenansicht eine erfindungsgemäße Leuchtvorrichtung gemäß einer zweiten Ausführungsform;
- Fig.11: zeigt in Draufsicht eine erfindungsgemäße Leuchtvorrichtung gemäß einer dritten Ausführungsform;
- Fig.12: zeigt als Schnittdarstellung in Seitenansicht eine erfindungsgemäße Leuchtvorrichtung gemäß einer vierten Ausführungsform;
- Fig.13: zeigt als Schnittdarstellung in Seitenansicht einen Ausschnitt aus einer Vorstufe einer erfindungsgemäßen Leuchtvorrichtung gemäß einer fünften Ausführungsform;
- Fig.14: zeigt in Seitenansicht ein elektrisches Verbindungselement der Leuchtvorrichtung gemäß der fünften Ausführungsform;
- Fig.15: zeigt als Schnittdarstellung in Seitenansicht einen Ausschnitt aus einer folgenden Vorstufe der Leuchtvorrichtung gemäß der fünften Ausführungsform mit einem eingelegten Verbindungselement;
- Fig.16: zeigt als Schnittdarstellung in Seitenansicht einen Ausschnitt aus einer weiteren Vorstufe der Leuchtvorrichtung gemäß der fünften Ausführungsform;
- Fig.17: zeigt als Schnittdarstellung in Seitenansicht die fertige Leuchtvorrichtung gemäß der fünften Ausführungsform;
- Fig.18: zeigt als Schnittdarstellung in Seitenansicht eine Leuchtvorrichtung gemäß einer sechsten Ausführungsform; und
- Fig.19: zeigt als Schnittdarstellung in Seitenansicht eine Leuchtvorrichtung gemäß einer siebten Ausführungsform.

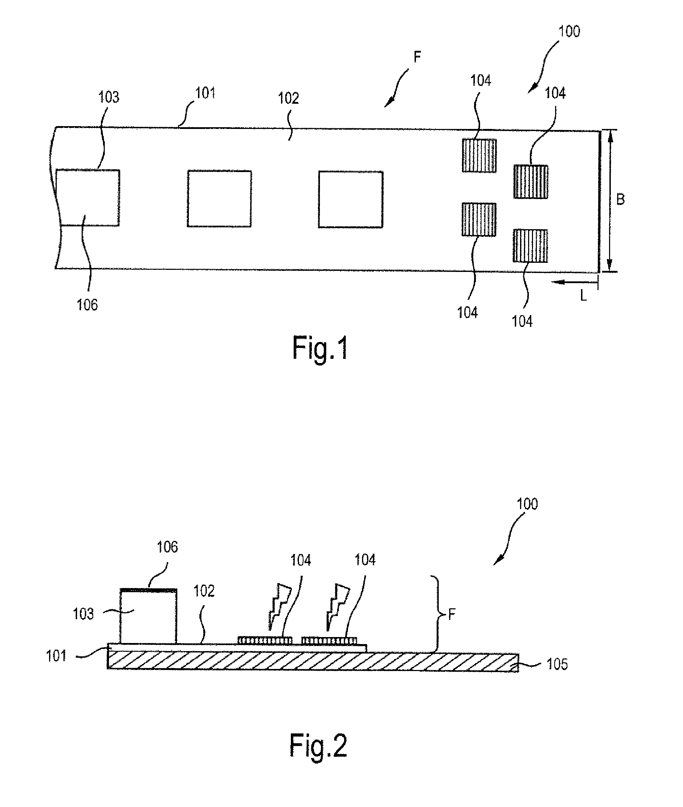

**Fig.1** zeigt in Draufsicht einen endseitigen Ausschnitt aus einem Leuchtband F in Form eines LED-Leuchtbands als Vorstufe einer Leuchtvorrichtung 100 gemäß einer ersten Ausführungsform. Das Leuchtband F weist ein bandförmiges Substrat in Form einer bandförmigen, flexiblen Leiterplatte 101 auf, deren Oberseite oder Vorderseite 102 gezeigt ist. Die Leiterplatte 101 kann beispielsweise Polyimid als Basismaterial aufweisen. Auf der Vorderseite 102 sind mehrere Leuchtdioden (LEDs) 103 äquidistant in Reihe angeordnet. Die Leuchtdioden können elektrisch über mehrere (hier: vier) an der Vorderseite 102 angeordnete elektrische Kontaktfelder oder Anschlussfelder 104 elektrisch kontaktiert werden. Eine zugehörige Verdrahtung der Leiterplatte 101 ist nicht gezeigt, aber vorhanden.

Die Anschlussfelder 104 sind seitlich (bezüglich einer Breite B der Leiterplatte 101) äquidistant versetzt. Zudem sind die Anschlussfelder 104 bezüglich einer Länge L der Leiterplatte 101 in zwei Reihen abwechselnd versetzt. Ein solche Anordnung vereinfacht eine mechanisch sichere Befestigung von Anschlusselementen und beugt möglichen Kurzschlüssen bei einer weiterhin kompakten Anordnung vor.

**Fig.2** zeigt in Seitenansicht einen Ausschnitt aus dem auf einem Träger 105 aufliegenden Leuchtband F als einer weiteren Vorstufe der Leuchtvorrichtung 100. Der Träger 105 mag insbesondere aus Silikon oder aus einem anderen elastischen Material bestehen, um die spätere Leuchtvorrichtung 100 zerstörungsfrei biegen zu können, insbesondere elastisch biegen zu können. Der Träger 105 mag in Frontalansicht entlang der Länge L als flache Unterlage oder, bevorzugt, in U-Form ausgestaltet sein. In den im Profil U-förmigen Träger 105 mag das Leuchtband F insbesondere eingelegt sein. Ein U-förmiger Träger 105 kann insbesondere als Form für ein späteres Einfüllen von Vergussmasse(n) dienen, wobei er ein Einfüllen einer Vergussmasse durch das Bereitstellen der Seitenwände vereinfacht.

Die Leuchtdiode 103 ist hier eine nach oben abstrahlende Leuchtdiode ("Top-LED") mit einer obenliegenden Emitterfläche 106.

Die Anschlussfelder 104 werden in diesem Herstellungsstadium inhibitiert, wie durch die gezackten Pfeile angedeutet. Dadurch wird ihre Haftfähigkeit gegenüber einer folgend auf sie gegosssenen Vergussmasse reduziert.

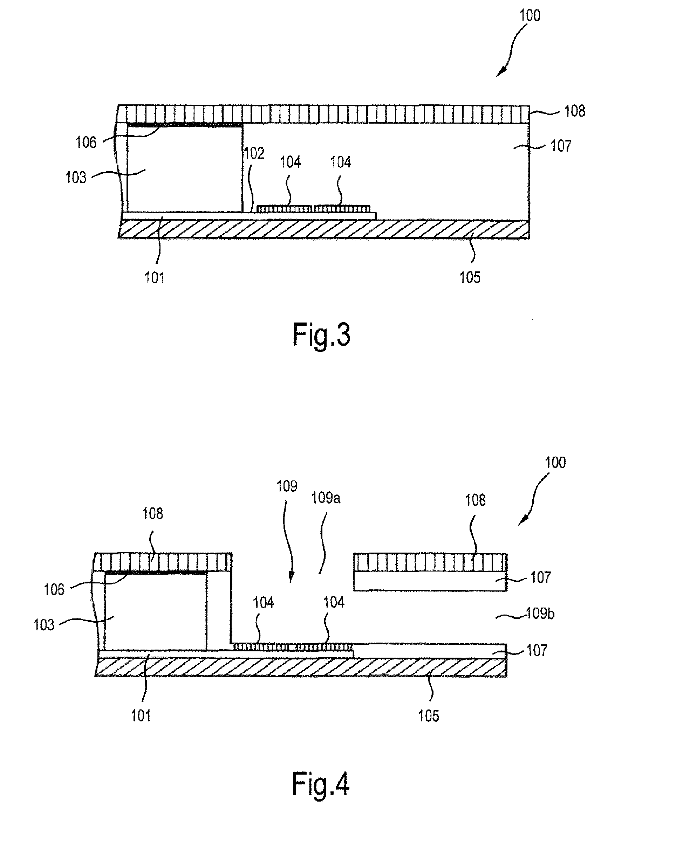

**Fig.3** zeigt als Schnittdarstellung in Seitenansicht einen Ausschnitt aus dem nun vergossenen Leuchtband F als noch einer weiteren Vorstufe der Leuchtvorrichtung 100.

Das Leuchtband F ist mittels zweier erster Vergussmassen 107, 108 vergossen, nämlich einer unteren Vergussmasse 107 und einer oberen Vergussmasse 108. Die untere Vergussmasse 107 ist hier blickdichtes Silikon und bedeckt die Seiten, aber nicht die Emitterflächen 106 der Leuchtdioden 103. Die untere Vergussmasse 107 bedeckt ferner die restliche Leiterplatte 101 einschließlich der Anschlussfelder 104. Auf der unteren Vergussmasse 107 liegt eine Lage der oberen Vergussmasse 108, welche die Emitterflächen 106 bedeckt. Die obere Vergussmasse 108 besteht aus transparentem oder transluzentem Silikon. Der Träger 105, die untere Vergussmasse 107 und die oberen Vergussmasse 108 stehen stirnseitig oder endständig über die Leiterplatte 101 bzw. das Leuchtband F hinaus (in Fig.3 nach rechts).

**Fig.4** zeigt das vergossene LED-Leuchtband F in einer zu Fig.3 analogen Darstellung in noch einer weiteren Vorstufe der erfindungsgemäßen Leuchtvorrichtung 100. In dieser Vorstufe ist in der ersten Vergussmasse 107, 108 eine Aussparung oder Ausschnitt 109 erzeugt worden, welcher die Oberfläche der Anschlussfelder 104 direkt von oben zugänglich freilegt. Der Ausschnitt 109 weist einen oberhalb der Anschlussfelder 104 vorhandenen, nach oben offenen Teilbereich 109a auf, von dem ein sich seitlich erstreckender, nach außen führender Kanal 109b abgeht. Der Kanal 109b mündet hier in eine endständige oder stirnseitige Fläche der Leuchtvorrichtung 100. Der Kanal 109b verläuft in der unteren Vergussmasse 107 und ist seitlich (aber nicht endständig) geschlossen und weist insbesondere eine Form eines Rohrs auf. Der Kanal 109b mag im Profil bezüglich seiner Längserstreckung insbesondere eine rechteckige Grundform aufweisen.

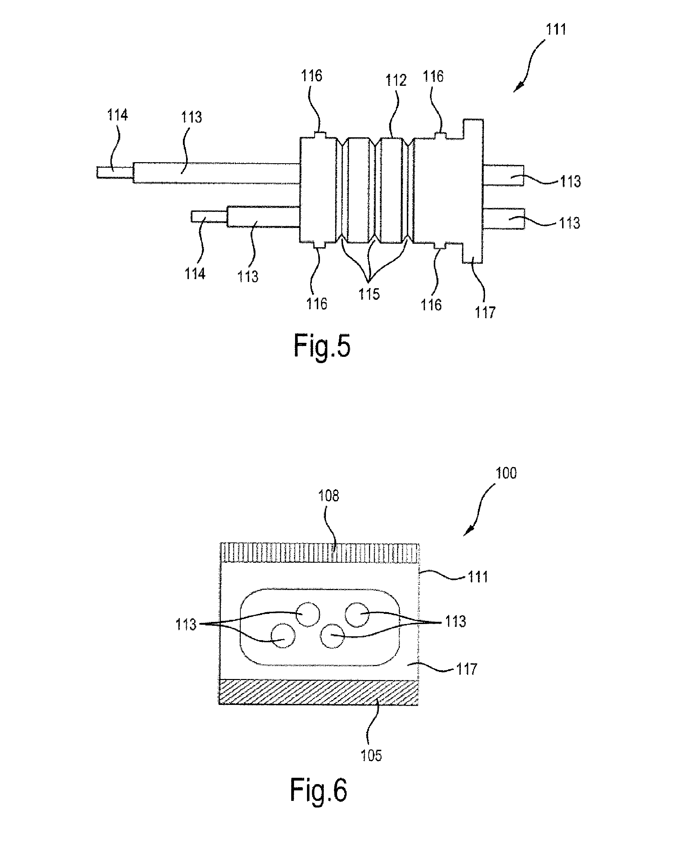

**Fig.5** zeigt in Seitenansicht ein elektrisches Verbindungselement 111 zur Verwendung mit der Leuchtvorrichtung 100, insbesondere zum außenseitigen Einsatz in den Kanal 109b. Das Verbindungselement 111 weist einen Körper 112 aus Kunststoff auf, durch welchen vier elektrische Leitungen 113 hindurchgeführt sind. Die elektrischen Leitungen 113 sind als ummantelte Drähte ausgeführt. Die elektrischen Leitungen 113 sind fest mit dem Körper 112 verbunden. Die elektrischen Leitungen 113 sind auf einer zum Anschluss an ein jeweiliges Anschlussfeld 104 vorgesehenen Seite so ausgebildet, dass ihre Enden 114 das jeweils vorgesehene Anschlussfeld 104 problemlos kontaktieren können bzw. damit verbunden werden können. Dazu sind die Enden 114 beispielsweise paarweise unterschiedlich weit von dem Körper 112 entfernt.

Der Körper 112 weist drei seitlich umlaufende Rillen 115 auf, um einen flächigen Verguss des Körpers 112 zu unterstützen, insbesondere mittels einer Kapillarwirkung.

Der Körper 112 weist zudem an jeder seiner Seiten (der Mantelfläche) Abstandshalter 116 auf, um so einen allseitigen Verguss des Körpers 112 zu unterstützen.

An einer endständigen Position des Körpers 112, welche zur außenseitigen Anordnung vorgesehen ist, weist der Körper 112 eine seitlich (lateral) vorstehende, umlaufende Wandung 117 auf. Diese dient zum außenseitigen Aufsatz auf den Kanal 109b und kann diesen verschließen.

**Fig.6** zeigt in Frontalansicht eine Endfläche der unfertigen Leuchtvorrichtung 100 mit dem eingesetzten elektrischen Verbindungselement 111. Die elektrischen Leitungen 113 sind analog zu den Anschlussfeldern 104 seitlich versetzt, um eine Kontaktierung zu erleichtern und einen Kurzschluss zu unterdrücken.

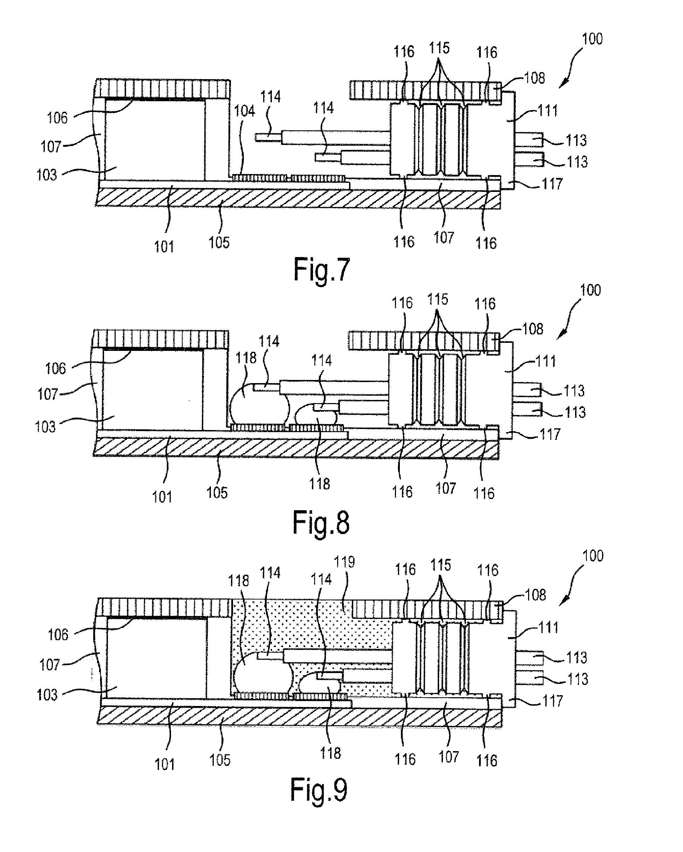

**Fig.7** zeigt als Schnittdarstellung in Seitenansicht einen Ausschnitt aus noch einer weiteren Vorstufe der Leuchtvorrichtung 100 mit dem von außen in den Kanal 109b eingeführten oder eingesetzten Verbindungselement 111. Diese Vorstufe folgt der in Fig.4 gezeigten Vorstufe. Das Verbindungselement 111 dient als Stopfen und sperrt den Kanal 109b nach außen ab. Die elektrischen Leitungen 113 stehen nach außen vor und können so extern angeschlossen werden.

**Fig.8** zeigt einen Ausschnitt aus noch einer weiteren Vorstufe der Leuchtvorrichtung 100. In dieser Vorstufe, welche der Vorstufe aus Fig.7 folgt, sind die freiliegenden Enden 114 der elektrischen Leitungen 113 mit denjenigen jeweiligen Anschlussfeldern 104 verbunden, hier: mit Lot 118 verlötet, worden, über welchen sie angeordnet sind. Diese Verlötung ist besonders leicht umzusetzen, da die freiliegenden Enden 114 und die Anschlussfelder 104 von oben zugänglich sind und räumlich ausreichend weit voneinander verteilt sind.

**Fig.9** zeigt die fertige Leuchtvorrichtung 100. Bei der fertigen Leuchtvorrichtung 100 ist der Ausschnitt 109 vollständig mit einer zweiten Vergussmasse 119 vergossen worden. Aufgrund der Abstandshalter 116 und der Rillen 115 umgibt die zweite Vergussmasse 119 den Körper 112 im Wesentlichen vollständig innerhalb des Kanals 109b. Die Wand oder Wandung 117 verhindert, dass die zweite Vergussmasse 119 aus dem Kanal 109b herausfließen konnte. Die zweite Vergussmasse 119 wird bis zu dem Niveau der oberen Vergussmasse 108 aufgefüllt. Also sind die Anschlussfelder 104 und das Verbindungselement 111 mittels der zweiten Vergussmasse 119 vergossen.

Die fertige Leuchtvorrichtung 100 ist bezüglich ihrer Längsausrichtung hochgradig zerstörungsfrei biegbar. Das elektrische Verbindungselement 111 ermöglicht dabei eine zugentlastete Verbindung zwischen den elektrischen Leitungen 113 und den Anschlussfeldern 104 im Falle einer gebogenen Leuchtvorrichtung 100.

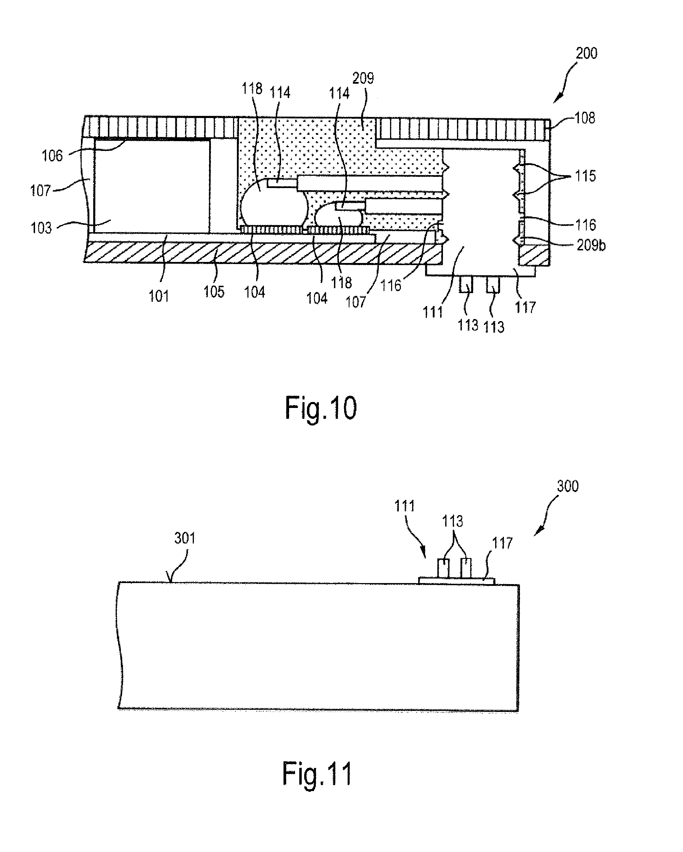

**Fig.10** zeigt eine zu der Leuchtvorrichtung 100 ähnliche Leuchtvorrichtung 200 gemäß einer zweiten Ausführungsform. Im Gegensatz zu der Leuchtvorrichtung 100 ist bei der Leuchtvorrichtung 200 der Kanal 209b des Ausschnitts 209 nach unten gerichtet und mündet also in eine Unterseite der Leuchtvorrichtung 200. Also stehen auch die elektrischen Leitungen 113 nach unten hervor. Der Kanal 209b ist durch die untere Vergussmasse 107 und den Träger 105 geführt.

**Fig.11** zeigt in Draufsicht eine Leuchtvorrichtung 300 gemäß einer dritten Ausführungsform. Bei der Leuchtvorrichtung 300 ist der Kanal des Ausschnitts zur Seite gerichtet und mündet also in eine Längsseite 301 der Leuchtvorrichtung 300. Also stehen auch die elektrischen Leitungen 113 seitlich hervor. Der Kanal 209b kann insbesondere durch eine Seitenwand eines im Profil U-förmigen Trägers 105 geführt sein.

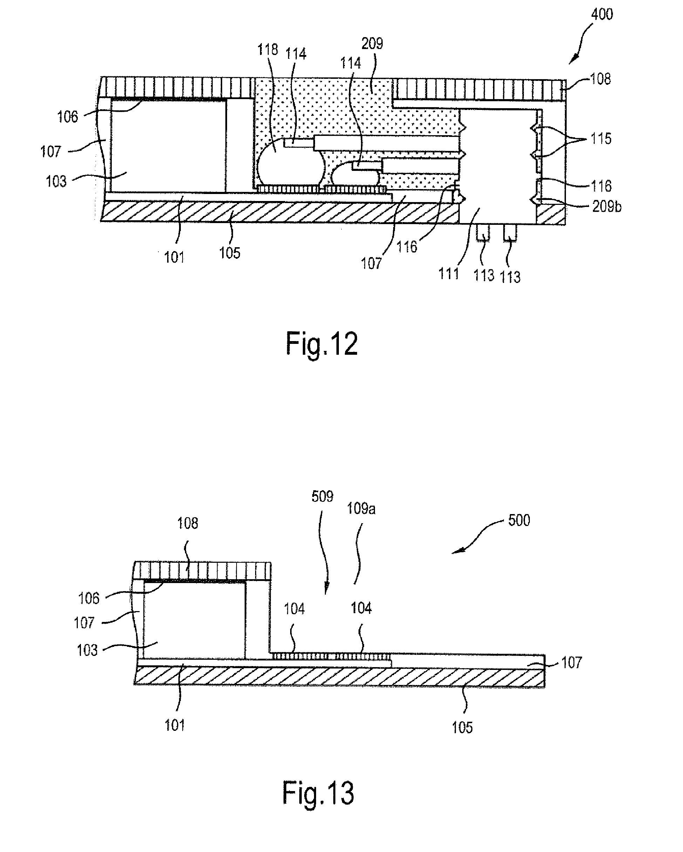

**Fig.12** zeigt als Schnittdarstellung in Seitenansicht eine Leuchtvorrichtung 400 gemäß einer vierten Ausführungsform. Die Leuchtvorrichtung 400 ist ähnlich zu der Leuchtvorrichtung 200 aufgebaut, weist aber ein unterschiedliches elektrisches Verbindungselement 411 auf. Das elektrische Verbindungselement 411 weist im Gegensatz zu dem Verbindungselement 111 keine seitlich umlaufende Wandung 117 auf, ist aber sonst ähnlich aufgebaut. Vielmehr weist der Körper 412 des Verbindungselements 411 an seinem außenseitigen Ende der Mantelfläche eine glatte Form auf, welche in einer Presspassung dicht in den Kanal 209b einsetzbar ist. Dadurch ragen nur noch die elektrischen Leitungen 113 aus der Leuchtvorrichtung 400 hervor.

Die elektrischen Leitungen 113 ragen hierbei anschlussfeldseitig aus der Mantelfläche des Verbindungselements 411 hervor und verlaufen in dem Körper 412 im Wesentlichen rechtwinklig.

**Fig.13** zeigt als Schnittdarstellung in Seitenansicht einen Ausschnitt aus einer Vorstufe einer Leuchtvorrichtung 500 gemäß einer fünften Ausführungsform ähnlich zu der in Fig.4 gezeigten Vorstufe. Bei der Leuchtvorrichtung 500 weist der Ausschnitt 509 nun keinen seitlich geschlossenen Kanal mehr auf, sondern ist vollflächig nach oben offen. Der Ausschnitt 509 kann also auch als ein nach außen führender, offener Kanal angesehen werden. Dies vereinfacht eine Einbringung des Ausschnitts 509. Dabei können (nicht dargestellte) Seitenwände des Trägers 105 eine seitliche Begrenzung des Ausschnitts 509 bereitstellen. Der Ausschnitt 509 öffnet sich jedoch zu der Stirnseite hin.

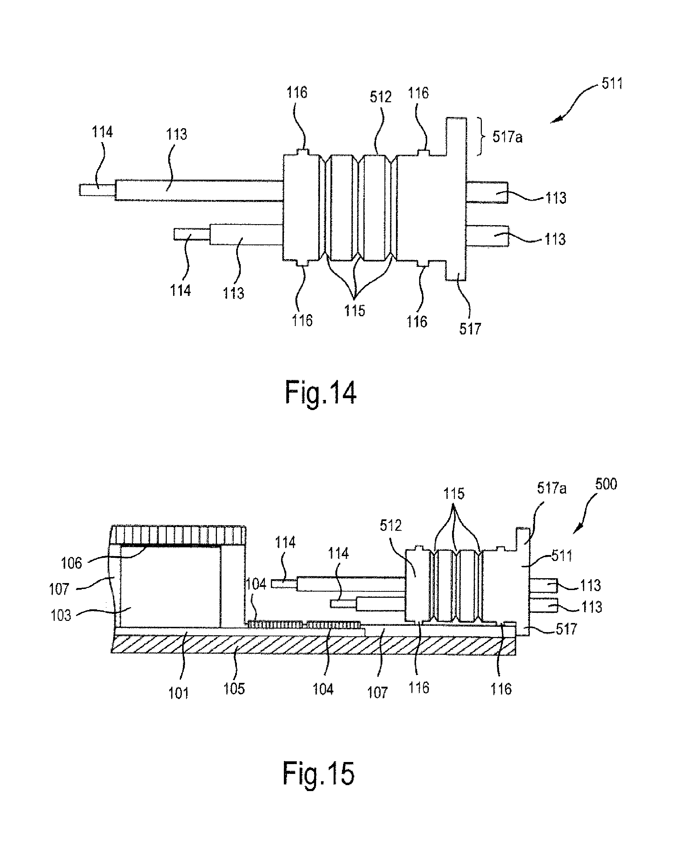

**Fig.14** zeigt in Seitenansicht ein elektrisches Verbindungselement 511 zur Verwendung mit der Leuchtvorrichtung 500. Das elektrische Verbindungselement 511 ist ähnlich zu dem Verbindungselement 111 aufgebaut, wobei jedoch nun die Wandung 517 des Körpers 512 eine bezüglich ihrer Umfangslage ungleichmäßige Höhe aufweist. Dadurch kann, insbesondere mittels eines Bereichs 517a der Wandung 517 mit der höchsten Höhe, eine maximale Einfüllhöhe der zweiten Vergussmasse 119 definiert werden. Die Wandung 517 dient weiterhin dem Versperren des Ausschnitts 509 nach außen.

**Fig.15** zeigt einen Ausschnitt aus einer folgenden Vorstufe der Leuchtvorrichtung 500, bei dem das Verbindungselement 511 nun in den Ausschnitt 509 eingelegt ist. Auch hier entspricht die Lage der Enden 114 der elektrischen Leitungen 113 in Draufsicht der Lage der Anschlussfelder 104.

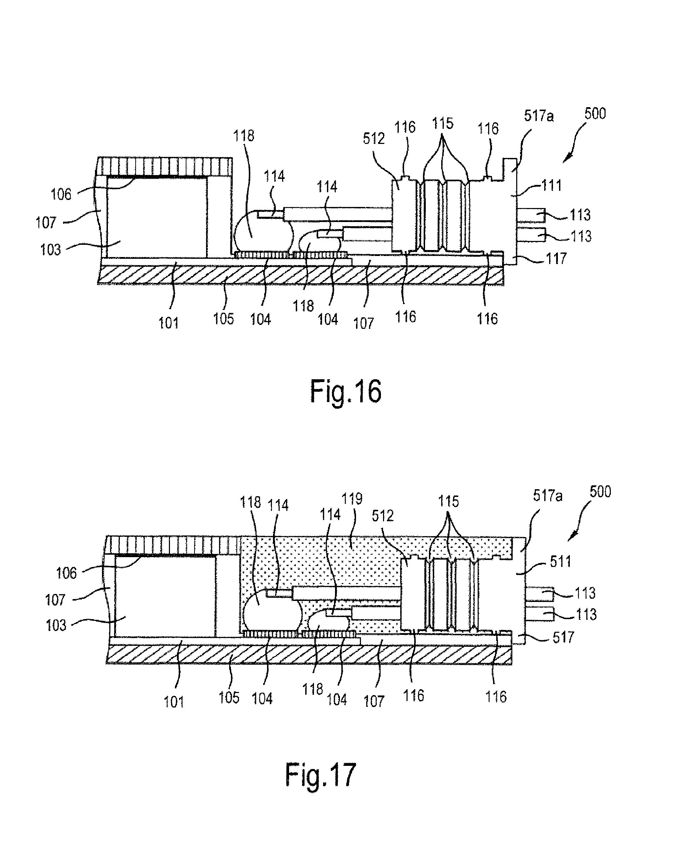

**Fig.16** zeigt eine weitere Vorstufe der Leuchtvorrichtung 500, bei welcher die Enden 114 und die Anschlussfelder 104 durch Lot 118 mechanisch und elektrisch miteinander verbunden sind.

**Fig.17** zeigt die fertige Leuchtvorrichtung 500, bei welcher der Ausschnitt 509 mit der zweiten Vergussmasse 119 vergossen ist. Der Ausschnitt 509 ermöglicht eine besonders vollständige (inklusionsfreie) Bedeckung des Körpers 512 (bis auf die Wandung 517) mit der zweiten Vergussmasse 119.

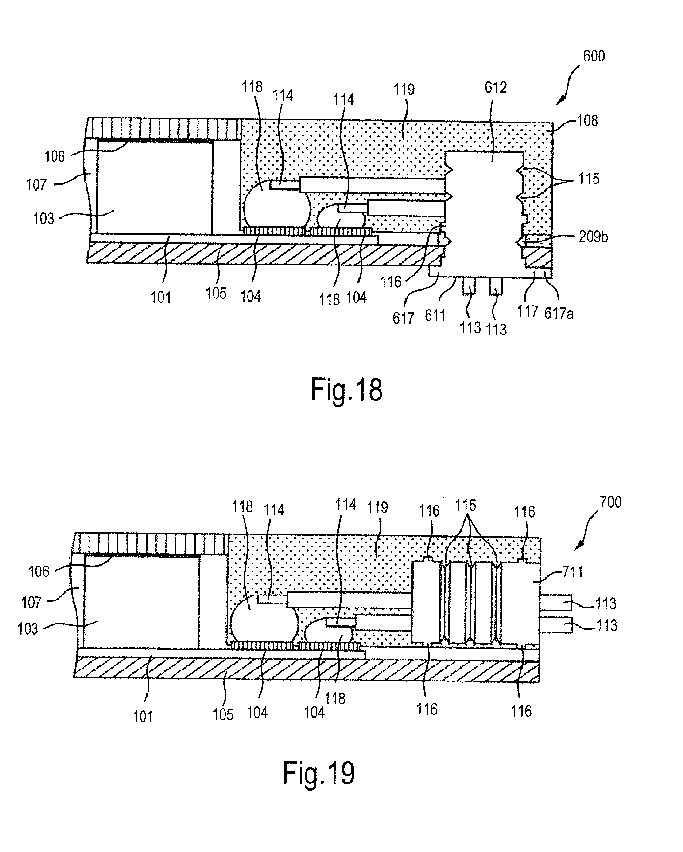

**Fig.18** zeigt eine Leuchtvorrichtung 600 gemäß einer sechsten Ausführungsform. Die Leuchtvorrichtung 600 kombiniert die Ausgestaltung der Leuchtvorrichtung 500 mit einem ähnlich zu der Leuchtvorrichtung 200 nach unten ausgerichteten elektrischen Verbindungselement 611. Hierbei definiert der Bereich 617a der Wandung 617 des Körpers 612 mit der höchsten Höhe eine stirnseitige Erstreckung der zweiten Vergussmasse 119.

Bei dieser Leuchtvorrichtung 600 wird es bevorzugt, dass sie in ihrer Vorstufe, bei der die Vergussmasse 119 noch nicht eingefüllt ist, mit einem oder mehreren Formteilen (o.Abb.) lösbar kombiniert wird, um die zweite Vergussmasse 119 definiert eingießen (oder einspritzen) zu können.

**Fig.19** zeigt als Schnittdarstellung in Seitenansicht eine Leuchtvorrichtung 700 gemäß einer siebten Ausführungsform. Die Leuchtvorrichtung 700 kombiniert die Ausgestaltung der Leuchtvorrichtung 500 mit einem elektrischen Verbindungselement 711, welches keine zum Versperren des Ausschnitts 509 vorgesehene, seitlich vorstehende Wandung aufweist.

Auch bei dieser Leuchtvorrichtung 700 wird es bevorzugt, dass sie in ihrer Vorstufe, bei der die Vergussmasse 119 noch nicht eingefüllt ist, mit einem oder mehreren Formteilen (o.Abb.) lösbar kombiniert wird, um die zweite Vergussmasse 119 definiert eingießen (oder einspritzen) zu können, und zwar auch bei einem seitlich ausgerichteten elektrischen Verbindungselement 711.

Selbstverständlich ist die vorliegende Erfindung nicht auf die gezeigten Ausführungsbeispiele beschränkt.

So kann das Anschlusselement für sämtliche Leuchtvorrichtungen grundsätzlich stirnseitig, nach unten oder an einer Seitenwand herausgeführt oder ausgerichtet sein.

Auch ist die Erfindung nicht auf Leuchtbänder beschränkt.

### Bezugszeichenliste

- 100: Leuchtvorrichtung
- 101: Leiterplatte
- 102: Vorderseite der Leiterplatte
- 103: Leuchtdiode
- 104: Anschlussfeld
- 105: Träger
- 106: Emitterfläche der Leuchtdiode
- 107: erste, untere Vergussmasse
- 108: erste, obere Vergussmasse
- 109: Ausschnitt der ersten Vergussmasse
- 109a: nach oben offener Teilbereich des Ausschnitts
- 109b: Kanal
- 111: Verbindungselement
- 112: Körper des Verbindungselements
- 113: elektrische Leitung des Verbindungselements
- 114: Ende der elektrischen Leitung
- 115: Rille des Körpers
- 116: Abstandshalter des Körpers
- 117: seitlich vorstehende Wandung des Körpers
- 118: Lot
- 119: zweite Vergussmasse
- 200: Leuchtvorrichtung
- 209: Ausschnitt
- 209b: Kanal des Ausschnitts
- 300: Leuchtvorrichtung
- 301: Längsseite der Leuchtvorrichtung
- 400: Leuchtvorrichtung
- 411: elektrisches Verbindungselement
- 412: Körper des Verbindungselements
- 500: Leuchtvorrichtung
- 509: Ausschnitt
- 511: elektrisches Verbindungselement
- 512: Körper
- 517: Wandung
- 517a: Bereich der Wandung mit der höchsten Höhe
- 600: Leuchtvorrichtung
- 611: elektrisches Verbindungselement
- 612: Körper
- 617: Wandung
- 617a: Bereich der Wandung mit der höchsten Höhe
- 700: Leuchtvorrichtung
- 711: elektrisches Verbindungselement
- B: Breite der leiterplatte
- F: Leuchtband
- L: Länge der Leiterplatte

## Patentansprüche

1. Leuchtvorrichtung (100; 200; 300; 400; 500; 600; 700), aufweisend mindestens eine mit mindestens einer ersten Vergussmasse (107, 108) vergossene Halbleiterlichtquelle (103),
wobei mindestens ein Bereich der Leuchtvorrichtung (100; 200; 300; 400; 500; 600; 700) aufweist:
- mindestens ein Anschlussfeld (104), das mit der mindestens einen Halbleiterlichtquelle (103) elektrisch verbunden ist und
- mindestens ein elektrisches Verbindungselement (111; 411; 511; 611; 711), das mindestens eine elektrische Leitung (113) aufweist,
wobei
- mindestens eine elektrische Leitung (113) mit einem zugehörigen Anschlussfeld (104) verbunden ist und an einem Ende aus der Leuchtvorrichtung (100; 200; 300; 400; 500; 600; 700) hervorragt, **dadurch gekennzeichnet, dass** das mindestens eine Anschlussfeld (104) und das mindestens eine elektrische Verbindungselement (111; 411; 511; 611; 711) in einem Ausschnitt (109; 209; 509) der ersten Vergussmasse (107, 108) angeordnet sind und mittels einer zweiten Vergussmasse (119) vergossen sind.

2. Leuchtvorrichtung (100; 200; 300; 400; 500; 600; 700) nach Anspruch 1, wobei das mindestens eine elektrische Verbindungselement (111; 411; 511; 611; 711) einen Körper (112; 412; 512; 612) aufweist, durch welchen mindestens eine elektrische Leitung hindurchgeführt ist.

3. Leuchtvorrichtung (100; 200; 300; 400; 500; 600; 700) nach Anspruch 2, wobei der Körper (112; 412; 512; 612) außenseitig mindestens eine Rille (115) aufweist.

4. Leuchtvorrichtung (100; 200; 300; 400; 500; 600; 700) nach einem der Ansprüche 2 oder 3, wobei der Körper (112; 412; 512; 612) außenseitig mindestens einen Abstandshalter (116) aufweist.

5. Leuchtvorrichtung (100; 200; 300; 400; 500; 600; 700) nach einem der Ansprüche 2 bis 4, wobei der Körper (112; 412; 512; 612) an der Seite, an welcher die mindestens eine zugehörige elektrische Leitung (113) aus der Leuchtvorrichtung (100; 200; 300; 400; 500; 600; 700) hervorschaut, eine seitlich vorstehende, umlaufende Wandung (117; 517; 617) aufweist.

6. Leuchtvorrichtung nach Anspruch 5, wobei die Wandung (517, 517a; 617, 617a) eine ungleichmäßige Höhe aufweist.

7. Leuchtvorrichtung (100; 200; 300; 400; 500; 600; 700) nach einem der vorhergehenden Ansprüche, wobei das mindestens eine elektrische Verbindungselement (111; 411; 511; 611; 711) zwei oder vier elektrische Leitungen (113) aufweist.

8. Leuchtvorrichtung (100; 200; 300; 400) nach einem der vorhergehenden Ansprüche, wobei das mindestens eine Anschlussfeld (104) bezüglich der mindestens einen ersten Vergussmasse (107, 108) mittels des mindestens einen Ausschnitts (109; 209) freigelegt ist und das mindestens eine elektrische Verbindungselement (111; 411) in einem nach außen führenden, seitlich geschlossenen Kanal (109b; 209b) untergebracht ist und den Kanal (109b; 209b) von außen verschließt.

9. Leuchtvorrichtung (500; 600; 700) nach einem der vorhergehenden Ansprüche, wobei das mindestens eine Anschlussfeld (104) bezüglich der mindestens einen ersten Vergussmasse (107, 108) mittels des mindestens einen Ausschnitts (509) freigelegt ist und das mindestens eine elektrische Verbindungselement (511; 611; 711) in einem nach außen führenden, offenen Kanal (509) untergebracht ist und den Kanal (509) von außen verschließt.

10. Leuchtvorrichtung (100; 200; 300; 400; 500; 600; 700) nach einem der vorhergehenden Ansprüche, wobei das mindestens eine Anschlussfeld (104) gegenüber einer das mindestens eine Anschlussfeld (104) direkt bedeckenden ersten Vergussmasse (107, 108) inhibitiert ist.

11. Leuchtvorrichtung (100; 200; 300; 400; 500; 600; 700) nach einem der vorhergehenden Ansprüche, wobei die mindestens eine erste Vergussmasse (107, 108) eine untere Vergussmasse (107), mittels welcher die mindestens eine Halbleiterlichtquelle (103) bis unterhalb ihrer Emitterfläche (106) vergossen ist, und eine obere Vergussmasse (108), mittels welcher die Emitterflächen (106) vergossen ist, aufweist.

12. Leuchtvorrichtung (100; 200; 300; 400; 500; 600; 700) nach einem der vorhergehenden Ansprüche, wobei die Leuchtvorrichtung (100; 200; 300; 400; 500; 600; 700) ein Leuchtband ist und die Bereiche der Leuchtvorrichtung (100; 200; 300; 400; 500; 600; 700) endständige Bereiche sind.

13. Verfahren zum Herstellen einer Leuchtvorrichtung (100; 200; 300; 400; 500; 600; 700), wobei das Verfahren mindestens die folgenden Schritte aufweist:
- Bereitstellen einer Leuchtvorrichtung (F), welche mindestens eine Halbleiterlichtquelle (103) sowie mindestens ein Anschlussfeld (104), das mit der mindestens einen Halbleiterlichtquelle (103) elektrisch verbunden ist, aufweist, welche mittels mindestens einer ersten Vergussmasse (107, 108) vergossen sind,
- Entfernen eines Teils der ersten Vergussmasse (107, 108), so dass das mindestens eine Anschlussfeld (104) freiliegt und über einen Kanal (109b; 209b; 509) mit einer Außenseite verbunden ist,
- Einführen eines elektrischen Verbindungselements (111; 411; 511; 611; 711) mit mindestens einer elektrischen Leitung (113) in den Kanal (109b; 209b; 509), so dass das elektrische Verbindungselement (111; 411; 511; 611; 711) den Kanal (109b; 209b; 509) absperrt und die mindestens eine elektrische Leitung (113) nach außen vorsteht;
- Verbinden mindestens einer elektrischen Leitung (113) des elektrischen Verbindungselements (111; 411; 511; 611; 711) mit einem jeweiligen Anschlussfeld (104); und
- Vergießen des mindestens einen Anschlussfelds (104) und des mindestens einen elektrischen Verbindungselements (111; 411; 511; 611; 711) mit mindestens einer zweiten Vergussmasse (119).

14. Verfahren nach Anspruch 13, aufweisend die vorangehenden Schritte:
- Inhibitieren des mindestens einen Anschlussfelds (104);
- Vergießen der mindestens einen Halbleiterlichtquelle (103) sowie des mindestens einen Anschlussfelds (104) mit der mindestens einen ersten Vergussmasse (107, 108),
wobei das Inhibitieren des mindestens einen Anschlussfelds (104) ein Inhibitieren gegenüber der das mindestens eine Anschlussfeld (104) direkt bedeckenden ersten Vergussmasse (107) umfasst.

## Claims

1. Lighting device (100; 200; 300; 400; 500; 600; 700), having at least one semiconductor light source (103) cast with at least one first casting compound (107, 108),
wherein at least one region of the lighting device (100; 200; 300; 400; 500; 600; 700) has:
- at least one connection area (104), which is electrically connected to the at least one semiconductor light source (103), and
- at least one electrical connecting element (111; 411; 511; 611; 711), which has at least one electrical line (113),
wherein
- at least one electrical line (113) is connected to an associated connection area (104) and protrudes at one end out of the lighting device (100; 200; 300; 400; 500; 600; 700), **characterized in that** the at least one connection area (104) and the at least one electrical connecting element (111; 411; 511; 611; 711) are arranged in a cutout (109; 209; 509) in the first casting compound (107, 108) and are cast by means of a second casting compound (119).

2. Lighting device (100; 200; 300; 400; 500; 600; 700) according to Claim 1, wherein the at least one electrical connecting element (111; 411; 511; 611; 711) has a body (112; 412; 512; 612), through which at least one electrical line is passed.

3. Lighting device (100; 200; 300; 400; 500; 600; 700) according to Claim 2, wherein the body (112; 412; 512; 612) has at least one groove (115) on the outside.

4. Lighting device (100; 200; 300; 400; 500; 600; 700) according to either of Claims 2 and 3, wherein the body (112; 412; 512; 612) has at least one spacer (116) on the outside.

5. Lighting device (100; 200; 300; 400; 500; 600; 700) according to one of Claims 2 to 4, wherein the body (112; 412; 512; 612) has a laterally protruding, peripheral wall (117; 517; 617) on the side on which the at least one associated electrical line (113) emerges from the lighting device (100; 200; 300; 400; 500; 600; 700).

6. Lighting device according to Claim 5, wherein the wall (517, 517a; 617, 617a) has a nonuniform height.

7. Lighting device (100; 200; 300; 400; 500; 600; 700) according to one of the preceding claims, wherein the at least one electrical connecting element (111; 411; 511; 611; 711) has two or four electrical lines (113).

8. Lighting device (100; 200; 300; 400) according to one of the preceding claims, wherein the at least one connection area (104) is exposed with respect to the at least one first casting compound (107, 108) by means of the at least one cutout (109; 209), and the at least one electrical connecting element (111; 411) is accommodated in a laterally closed channel (109b; 209b) which leads outward and closes the channel (109b; 209b) on the outside.

9. Lighting device (500; 600; 700) according to one of the preceding claims, wherein the at least one connection area (104) is exposed with respect to the at least one first casting compound (107, 108) by means of the at least one cutout (509), and the at least one electrical connecting element (511; 611; 711) is accommodated in an open channel (509) which leads outward and closes the channel (509) on the outside.

10. Lighting device (100; 200; 300; 400; 500; 600; 700) according to one of the preceding claims, wherein the at least one connection area (104) is inhibited with respect to a first casting compound (107, 108) directly covering the at least one connection area (104).

11. Lighting device (100; 200; 300; 400; 500; 600; 700) according to one of the preceding claims, wherein the at least one first casting compound (107, 108) has a lower casting compound (107), by means of which the at least one semiconductor light source (103) is cast up to below its emitter face (106), and an upper casting compound (108), by means of which the emitter face (106) is cast.

12. Lighting device (100; 200; 300; 400; 500; 600; 700) according to one of the preceding claims, wherein the lighting device (100; 200; 300; 400; 500; 600; 700) is a lighting strip, and the regions of the lighting device (100; 200; 300; 400; 500; 600; 700) are end regions.

13. Method for producing a lighting device (100; 200; 300; 400; 500; 600; 700), wherein the method has at least the following steps:
- providing a lighting device (F), which has at least one semiconductor light source (103) and at least one connection area (104), which is electrically connected to the at least one semiconductor light source (103), which semiconductor light sources are cast by means of at least one first casting compound (107, 108);
- removing some of the first casting compound (107, 108), with the result that the at least one connection area (104) is exposed and is connected to an outer side via a channel (109b; 209b; 509);
- inserting an electrical connecting element (111; 411; 511; 611; 711) with at least one electrical line (113) into the channel (109b; 209b; 509), with the result that the electrical connecting element (111; 411; 511; 611; 711) shuts off the channel (109b; 209b; 509) and the at least one electrical line (113) protrudes outward;
- connecting at least one electrical line (113) of the electrical connecting element (111; 411; 511; 611; 711) to a respective connection area (104); and
- casting the at least one connection area (104) and the at least one electrical connecting element (111; 411; 511; 611; 711) with at least one second casting compound (119).

14. Method according to Claim 13, having the following preceding steps:
- inhibiting the at least one connection area (104);
- casting the at least one semiconductor light source (103) and the at least one connection area (104) to the at least one first casting compound (107, 108),
wherein inhibiting the at least one connection area (104) comprises inhibiting with respect to the first casting compound (107) which directly covers the at least one connection area (104).

## Revendications

1. Dispositif d'éclairage (100; 200; 300; 400; 500; 600; 700) présentant au moins une source de lumière à semiconducteurs (103) enrobée avec au moins une première masse d'enrobage (107, 108),
où au moins une zone du dispositif d'éclairage (100; 200; 300; 400; 500; 600; 700) présente :
- au moins un panneau de connexion (104) qui est connecté électriquement à l'au moins une source de lumière à semi-conducteurs (103), et
- au moins un élément de connexion électrique (111; 411; 511; 611; 711) qui présente au moins un câble électrique (113),
où
- au moins un câble électrique (113) est raccordé à un panneau de connexion associé (104) et dépasse du dispositif d'éclairage (100; 200; 300; 400; 500; 600; 700), au niveau d'une extrémité,
**caractérisé en ce que** l'au moins un panneau de connexion (104) et l'au moins un élément de connexion électrique (111; 411; 511; 611; 711) sont disposés dans une découpe (109; 209; 509) de la première masse d'enrobage (107, 108) et sont enrobés avec une seconde masse d'enrobage (119).

2. Dispositif d'éclairage (100; 200; 300; 400; 500; 600; 700) selon la revendication 1, où l'au moins un élément de connexion électrique (111; 411; 511; 611; 711) présente un corps (112 ; 412 ; 512 ; 612) à travers lequel est passé au moins un câble électrique.

3. Dispositif d'éclairage (100; 200; 300; 400; 500; 600; 700) selon la revendication 2, où le corps (112; 412; 512; 612) présente extérieurement au moins une rainure (115).

4. Dispositif d'éclairage (100; 200; 300; 400; 500; 600; 700) selon l'une des revendications 2 ou 3, où le corps (112; 412; 512; 612) présente extérieurement au moins un espaceur (116).

5. Dispositif d'éclairage (100; 200; 300; 400; 500; 600; 700) selon l'une quelconque des revendications 2 à 4, où le corps (112; 412; 512; 612) présente, sur le côté sur lequel l'au moins un câble électrique associé (113) apparaît comme dépassant du dispositif d'éclairage (100; 200; 300; 400; 500; 600; 700), une paroi circulaire (117; 517; 617) faisant saillie latéralement.

6. Dispositif d'éclairage selon la revendication 5, où la paroi (517, 517a; 617, 617a) présente une hauteur inégale.

7. Dispositif d'éclairage (100; 200; 300; 400; 500; 600; 700) selon l'une quelconque des revendications précédentes, où l'au moins un élément de connexion électrique (111; 411; 511; 611; 711) présente deux ou quatre câbles électriques (113).

8. Dispositif d'éclairage (100; 200; 300; 400) selon l'une quelconque des revendications précédentes, où l'au moins un panneau de connexion (104) est dénudé par rapport à l'au moins une première masse d'enrobage (107, 108), grâce à l'au moins une découpe (109 ; 209), et l'au moins un élément de connexion électrique (111; 411) est logé dans un canal (109b ; 209b), fermé latéralement et conduisant à l'extérieur, et obture de l'extérieur le canal (109b; 209b).

9. Dispositif d'éclairage (500; 600; 700) selon l'une quelconque des revendications précédentes, où l'au moins un panneau de connexion (104) est dénudé par rapport à l'au moins une première masse d'enrobage (107, 108), grâce à l'au moins une découpe (509), et l'au moins un élément de connexion électrique (511; 611; 711) est logé dans un canal (509), ouvert et conduisant à l'extérieur, et obture de l'extérieur le canal (509).

10. Dispositif d'éclairage (100; 200; 300; 400; 500; 600; 700) selon l'une quelconque des revendications précédentes, où l'au moins un panneau de connexion (104) est inhibé par rapport à une première masse d'enrobage (107, 108) recouvrant directement l'au moins un panneau de connexion (104).

11. Dispositif d'éclairage (100; 200; 300; 400; 500; 600; 700) selon l'une quelconque des revendications précédentes, où l'au moins une première masse d'enrobage (107, 108) présente une masse d'enrobage inférieure (107) avec laquelle l'au moins une source de lumière à semi-conducteurs (103) est enrobée jusqu'en dessous de sa surface d'émetteur (106), et une masse d'enrobage supérieure (108) avec laquelle est enrobée la surface d'émetteur (106).

12. Dispositif d'éclairage (100; 200; 300; 400; 500; 600; 700) selon l'une quelconque des revendications précédentes, où le dispositif d'éclairage (100; 200; 300; 400; 500; 600; 700) est un ruban lumineux, et les zones du dispositif d'éclairage (100; 200; 300; 400; 500; 600; 700) sont des zones terminales.

13. Procédé pour fabriquer un dispositif d'éclairage (100; 200; 300; 400; 500; 600; 700), où le procédé présente au moins les étapes suivantes :
- la fourniture d'un dispositif d'éclairage (F) qui présente au moins une source de lumière à semi-conducteurs (103) ainsi qu'au moins un panneau de connexion (104) qui est connecté électriquement à l'au moins une source de lumière à semi-conducteurs (103) lesquels sont enrobés avec au moins une première masse d'enrobage (107, 108),
- la suppression d'une partie de la première masse d'enrobage (107, 108), de sorte que l'au moins un panneau de connexion (104) est dénudé et est relié à un côté extérieur, par un canal (109b; 209b; 509),
- l'introduction, dans le canal (109b; 209b; 509), d'un élément de connexion électrique (111; 411; 511; 611; 711) comportant au moins un câble électrique (113), de sorte que l'élément de connexion électrique (111; 411; 511; 611; 711) obture le canal (109b; 209b; 509), et l'au moins un câble électrique (113) est en saillie vers l'extérieur ;
- le raccordement d'au moins un câble électrique (113) de l'élément de connexion électrique (111; 411; 511; 611; 711) à un panneau de connexion respectif (104) ; et
- l'enrobage de l'au moins un panneau de connexion (104) et de l'au moins un élément de connexion électrique (111; 411; 511; 611; 711) avec au moins une seconde masse d'enrobage (119).

14. Procédé selon la revendication 13, présentant les étapes indiquées précédemment :
- l'inhibition l'au moins un panneau de connexion (104);
- l'enrobage de l'au moins une source de lumière à semi-conducteurs (103), ainsi que l'au moins un panneau de connexion (104), avec l'au moins une première masse d'enrobage (107, 108),
où l'inhibition de l'au moins un panneau de connexion (104) comprend une inhibition par rapport à la première masse d'enrobage (107) recouvrant directement l'au moins un panneau de connexion (104).
